Europäisches Patentamt

(19) European Patent Office    (11) Publication number:    **0 098 176**

Office européen des brevets    **A2**

(12)    # EUROPEAN PATENT APPLICATION

(21) Application number: 83303811.0    (51) Int. Cl.³: **H 01 L 23/04**
                                                    **H 01 L 21/50**

(22) Date of filing: 30.06.83

(30) Priority: 30.06.82 JP 112827/82

(43) Date of publication of application:
11.01.84 Bulletin 84/2

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Watanabe, Hisashi
Fujitsu Aobadai-ryo 2209 54-10, Shiratoridai
Midori-ku Yokohama-shi Kanagawa 227(JP)

(72) Inventor: Sugahara, Takehisa
Shirahatadai-jutaku 16-203, 1-11-1. Shirahatadai
Miyamae-ku Kawasaki-shi Kanagawa 213(JP)

(74) Representative: Fane, Christopher Robin King et al,
HASELTINE LAKE & CO. Hazlitt House 28 Southampton
Buildings Chancery Lane
London, WC2A 1AT(GB)

(54) The packaging of semiconductor chips.

㊼ In hermetically sealing a package for a semiconductor chip (50) a ceramic receptacle (41) having leads (42) and a metal frame (43) fixed to the ceramic receptacle has a metal lid (44) set inside the metal frame (43) and the metal lid and the metal frame joined by laser welding. By using such a laser welding technique, damage to the chip by overheating can be avoided, while still permitting desirably high productivity.

Fig. 4

- 1 -

# THE PACKAGING OF SEMICONDUCTOR CHIPS.

The present invention relates to the packaging of semiconductor chips.

Semiconductor chips of integrated circuits (IC's), large scale integrated circuits (LSI's), and the like are usually packaged to protect them from the surrounding environment, particularly from the effects of moisture and dust. In order to ensure the reliability of such a semiconductor device, the package is generally hermetically sealed. Specifically, the ceramic receptacle accommodating the semiconductor chip has been hermetically sealed with a lid by solder sealing, glass sealing, or seam resistance welding.

According to the solder sealing method, a preform or frame of solder, such as a gold-tin alloy or lead-tin alloy, is disposed between a gold- or nickel-plated portion of a top surface of a multilayer ceramic receptacle and a gold- or nickel-plated portion of a bottom surface of a lid made of metal or ceramic. The thus assembled package is then heated at a temperature above the melting point of the solder to melt the solder and join the receptacle and the lid. The gold or nickel coating is generally formed on metallizing layer portions of the ceramic receptacle and lid. While this method is relatively easy, gold-tin solder is expensive and lead-tin solder can be difficult to handle due to its softness and low elasticity. The join strength of the solder is also lower compared with the glass sealing method and the seam resistance welding method.

According to the glass sealing method, low melting point glass is used instead of solder to join the ceramic receptacle and lid. The glass has to be heated at approximately 500°C to melt, however, which may affect properties of the semiconductor chip. The glass sealing method can be preferably applied to a ceramic dual-in-line package (Cer-DIP).

According to the seam resistance welding method, a metal frame fixed on the multilayer ceramic receptacle is welded to the metal lid. In this case, the semiconductor chip accommodated within the receptacle is not substantially heated. The joining portions of the frame and the lid, however, should be plated with gold or nickel, resulting in higher costs. Also, the packages have to be seam welded one by one, which may give low productivity. Further the seam resistance welding method cannot easily be applied on a face down type pin grid array package, provided with a large number of pins and a semiconductor chip which are arranged on a bottom surface of a ceramic receptacle, since the pins may block electrodes of a welder from coming into contact with the lid.

It is desirable to provide a method for hermetically sealing a face down type pin grid array package without heating a semiconductor chip strongly.

According to an embodiment of the present invention, a semiconductor device package can be produced by the steps of fixing a metal frame on a ceramic receptacle around a cavity of the receptacle, attaching a semiconductor chip within the cavity, interconnecting the semiconductor chip and leads of the ceramic receptacle, setting a metal lid inside the metal frame, whereby the outside surface of the metal lid faces the inside surface of the metal frame, and laser welding the metal frame and the metal lid to join the outside surface and the inside surface by means of a fine high-energy welding beam.

Reference will now be made, by way of example, to the accompanying drawings, in which:

Figure 1 is a schematic sectional view of a conventional multilayer ceramic package;

Fig. 2 is a schematic sectional view of a conventional Cer-DIP;

Fig. 3 is a schematic sectional view of a convention multilayer ceramic package which is sealed by a seam resistance welding method;

Fig. 4 is a schematic sectional view of a multilayer ceramic package according to an embodiment of the present invention;

Fig. 5 is a plan view of the package shown in Fig. 4;

Fig. 6 is a schematic perspective view of a metal frame of the package shown in Figs. 4 and 5;

Fig. 7 is a schematic sectional view of a face down type pin grip array package according to another embodiment of the present invention; and

Fig. 8 is a schematic plan view of the package shown in Fig. 7.

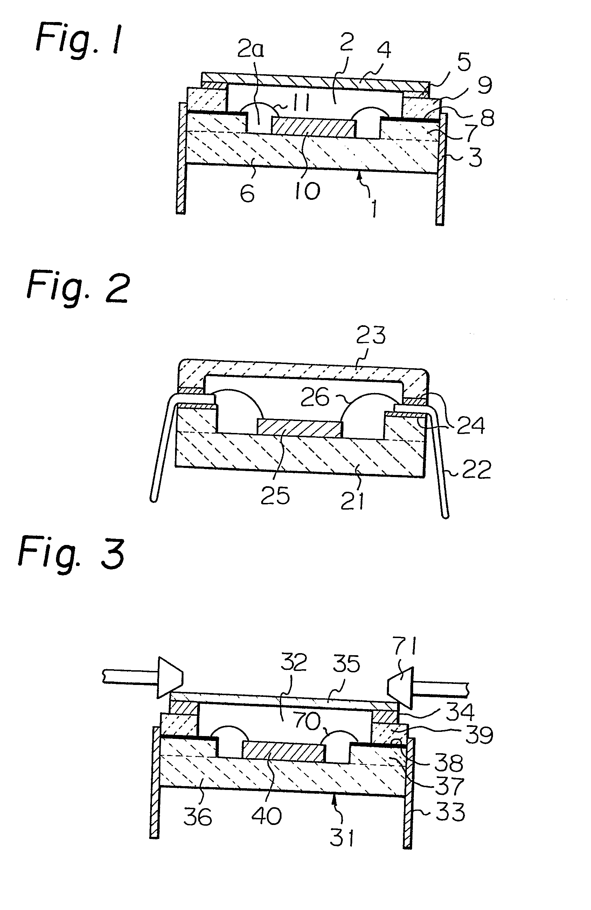

A prior multilayer ceramic package, as illustrated in Fig. 1, comprises a multilayer ceramic receptacle 1 with a cavity 2, leads 3, a lid 4 of metal (or ceramic), and a sealing material 5 of solder, e.g., gold-tin or lead-tin alloy, or low melting point glass. The multilayer ceramic receptacle 1 comprises a first ceramic layer 6, a second ceramic layer 7 with a recess 2a, metallizing layers 8 serving as inner conductor lines, a third ceramic layer 9, metallizing layers (not shown) for the leads 3, and a metallizing layer (not shown) for the sealing material 5 and is produced by a sintering technique.

The leads 3 are generally made of a metal with a thermal expansion coefficient equal or similar to that of the ceramic of the ceramic receptacle 1, such as an iron-nickel-cobalt alloy (e.g., kovar; a trade name) and iron-nickel alloy (e.g., 42 alloy). The leads 3 are fixed on the ceramic receptacle 1 by a brazing method (for example, by applying a silver-copper alloy on the metallizing layer of sides of the receptacle and by heating it at a temperature of from 700°C to 1000°C). After the fixation of the leads 3, an IC or LSI semiconductor chip 10 is attached onto the first ceramic layer 6 in the recess by using a suitable metal, e.g., a eutectic soldering alloy such as gold-silicon and gold-germanium. Then, in order to provide interconnection between the semiconductor chip 10 and the leads 3, wires 11 of gold or aluminum are attached to pads of the semiconductor chip 10 and to the metallizing layers 8 by a wire bonding technique.

The sealing material 5, in the shape of a frame, is arranged on the metallizing layer (not shown) of the third ceramic layer 9. The metal (or ceramic) lid 4 having a gold- or nickel-plate portion is arranged on the sealing material 5. The ceramic receptacle 1 with the lid 4 is heated at a temperature above the melting point of the solder or above the softening point of the low melting point glass, so that the lid 4 and the ceramic receptacle 1 are joined with the sealing material 5, whereby the semiconductor chip is hermetically sealed. In the case of a gold-tin alloy solder, a lead-tin alloy solder, and a low melting point glass, the heating temperatures are about 350°C, 300°C, and 500°C, respectively.

A Cer-DIP, as illustrated in Fig. 2, comprises a ceramic receptacle 21 with a cavity, leads 22, a ceramic lid 23, and a low melting glass sealing material 24. The leads 22 serve as inner conductor lines. A semiconductor chip 25 is attached on the ceramic receptacle 21 by using the eutectic soldering alloy. Wires 26 of gold or aluminum are provided between pads of the semiconductor chip 25 and the leads 22 by a wire bonding technique. The ceramic receptacle 21 and the ceramic lid 23 provided with the glass sealing material 24 therebetween are heated at a temperature above the softening point (about 500°C) of the low melting point glass binder 24 so as to join them therewith, whereby a hermetically sealed Cer-DIP is obtained.

Another multilayer ceramic package of the prior art is hermetically sealed by seam resistance welding, as illustrated in Fig. 3. The ceramic package comprises a multilayer ceramic receptacle 31 with a cavity 32, leads 33, a metal frame 34, and a metal lid 35. The multilayer ceramic receptacle 31 comprises a first ceramic layer 36, a second ceramic layer 37 with a recess, metallizing layers 38 for inner conductor lines, a third ceramic layer 39, metallizing layers (not shown) formed on the sides of the first and second ceramic layers 36 and 37, and another metallizing layer (not shown) formed on the top surface of the third ceramic layer 39 and is produced by a sintering technique. The leads 33, the metal frame 34, and the metal lid 35 are generally made of the iron-nickel-cobalt alloy and iron-nickel alloy, and are selectively plated with gold or nickel. The leads 33 and the metal frame 34 are generally simultaneously fixed on the first and second ceramic layers 36 and 37 and the third ceramic layer 39, respectively, by the brazing method. After the fixation of the metal frame 34, a semiconductor chip 40 is attached onto the first ceramic layer 36 and wires 70 are provided between pads of the chip 40 and the metallizing layers 38 in the above-mentioned manner. Then, the metal lid 35 is placed on the metal frame 34 in such a manner that the gold- or nickel- -plated portion of the lid 35 comes into contact with the gold- or nickel-plated portion of the frame 34. Two roller electrodes 71 press the metal lid 35, as illustrated in Fig. 3, and a welding current flows between the electrodes 71, whereby the metal lid 35 and the metal frame 34 are joined.

As described earlier, however, the above-mentioned conventional packages and packaging methods have disadvantages.

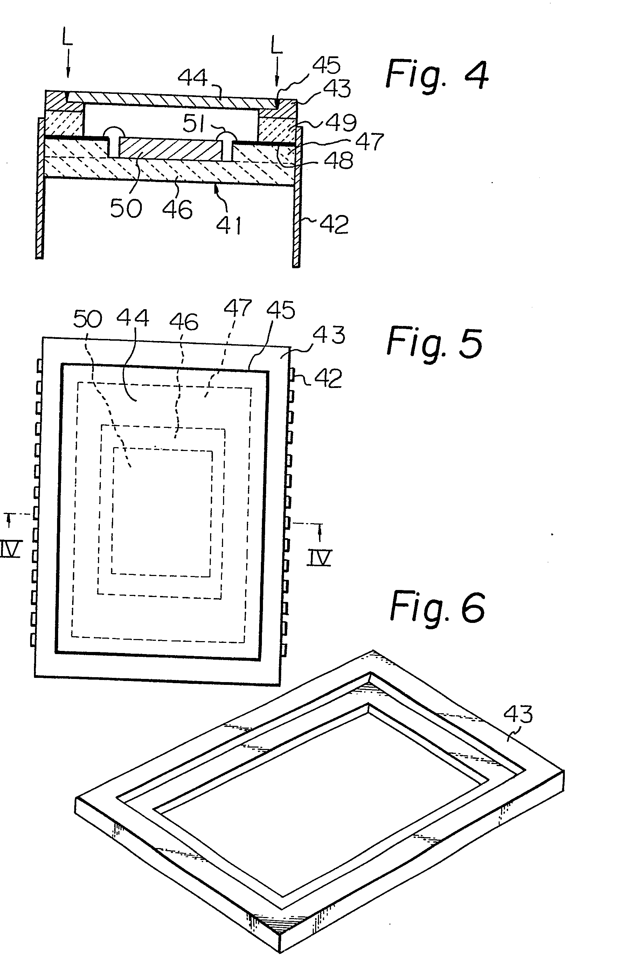

A multilayer ceramic package (Figs. 4 and 5) embodying the present invention comprises a multilayer ceramic receptacle 41, leads 42, a metal frame 43, and a metal lid 44 set inside the metal frame 43. The metal frame 43 and the metal lid 44 are joined by a weld metal 45 by means of laser welding so as to attain hermetic sealing of the package.

The multilayer ceramic receptacle 41 has the same structure as that of the above-mentioned multilayer ceramic receptacles 1 and 31 (Figs. 1 and 3).

The ceramic receptacle 41 comprises a first ceramic layer 46, a second ceramic layer 47 with a recess, metallizing layers 48 serving as inner conductor lines, a third ceramic layer 49, metallizing layers (not shown) for the leads 42, and a metallizing layer (not shown) formed on the top surface of the third ceramic layer 49 and is produced by a sintering technique.

The leads 42, the metal frame 43 (Fig. 6), and the metal lid 44 are made of metal with a thermal expansion coefficient equal or similar to that of the ceramic of the ceramic receptacle 41, such as iron-nickel-cobalt alloy and iron-nickel alloy. It is preferable to use Kovar or 42 alloy as the metal. The metal frame 43 is shaped as a rectangle with a vacant rectangular center and an L-shape cross-section, as illustrated in Figs. 4, 5 and 6. The metal lid 44 is placed inside the metal frame 43 on the thin portion of the frame 43. It is preferable that the metal lid 44 be level with the metal frame 43. It is not

necessary     to plate (i.e., coat) portions of the frame 43 and the lid 44 facing to each other with gold or nickel. It is possible to form the metal frame being a ring and having an L-shape cross-section and to form the metal lid being a disk.

The leads 42 are fixed on sides of the first and second ceramic layer 46 and 47 by brazing  on the metallizing layer (not shown) of the sides and by heating at a temperature of from 800°C to 1000°C. The metal frame 43 is fixed on the top surface of the third ceramic layer 49 in a similar manner to the leads 42. It is preferable in practice to fix the leads 42 and the frame 43 simultaneously.

A semiconductor chip 50 is attached onto the first ceramic layer 46 in the recess by inserting a piece of a gold foil or a gold-silicon or gold-germanium alloy film between the chip 50 and the ceramic layer 46 and then by heating and scrubbing them. For example, in the case of the use of a gold-silicon alloy film piece, the heating temperature is about 420°C. Wires 51 of gold or aluminum are attached to pads on the semiconductor chip 50 and to the metallizing layers 48 by a wire bonding technique to provide interconnection between the chip 50 and the leads 43.

Next, the metal lid 44 is set inside the metal frame 43. The edge portion of the lid 44 and the inside edge portion of the frame 43 are irradiated with laser light L under an inert atmosphere of argon or nitrogen so as to form the weld metal 45 between the lid 44 and the frame 43. Thus, the metal lid 44 and the metal frame 43 can be joined with the weld metal 45 to hermetically seal the package. The main characteristic of laser light is coherence. The power density is very high and can be aried by using an optical device, e.g., an optical lens. It is preferable to use a yttrium aluminum garnet (YAG), i.e., neodymium (Na)-doped $Y_3Al_5O_{12}$ laser or a $CO_2$ gas laser. The power density and the irradiation time per unit length of the laser light can be suitably determined, taking into consideration the depth of the weld metal 45, thickness of the lid 44, materials of the metal lid 44 and frame 43, and other conditions.

Laser welding for hermetically sealing a semiconductor device package can help to protect against the semiconductor chip 50 being affected by heat since the high rate and local heating of the laser light do not substantially raise the temperature of the chip 50,

The join strength of the weld metal 45 is also high, and the packaging cost can be reduced by eliminating use of a gold or nickel coating for the metal lid and metal frame and use of a gold-tin alloy solder. Furthermore, laser welding can be carried out in a relatively short period, so increasing productivity.

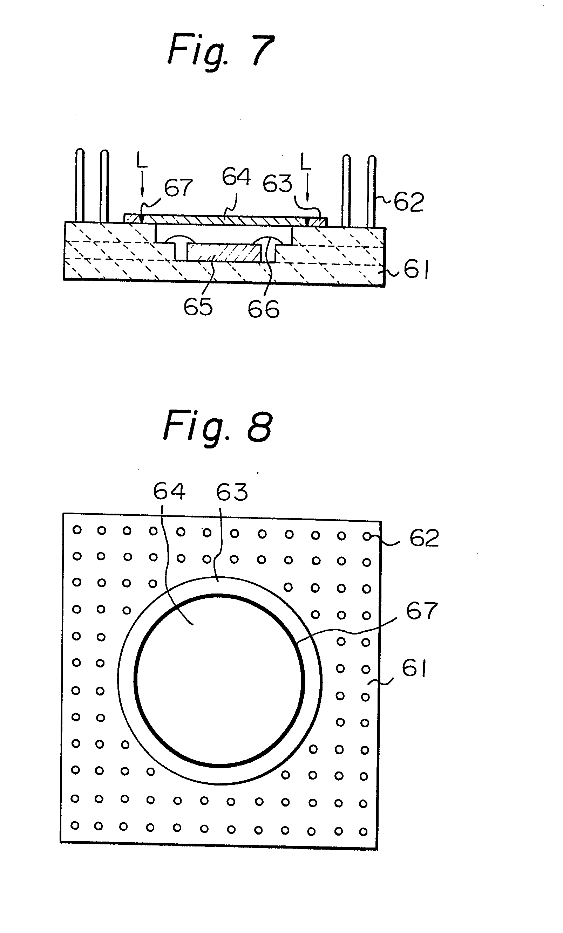

A face down type pin grid array package (Figs. 7 and 8) according to another embodiment of the present invention comprises a ceramic receptacle 61 with a cavity, a large number of pins 62, a metal frame 63, and a metal lid 64. The ceramic receptacle 61 is produced in practice as a multilayer ceramic body provided with fixed pins (i.e. outer lead portions of leads) 62 which are arranged in a bottom surface including the cavity.

The metal frame 63 is made of the above-mentioned metal and is shaped as a ring (Fig. 8) or a rectangle with a vacant rectangular center and a rectangular cross-section. The frame 63 is fixed on the bottom surface of the ceramic receptacle 61 around the cavity by a conventional braizing method. Then, a semiconductor chip 65 is attached onto the ceramic receptacle 61 in the cavity by means of the above-mentioned conventional method. Wires 66 of gold or aluminum are ⁀rmed by a wire bonding technique. Next, the metal lid 64 is set inside the metal frame 63 on the bottom surface of the ceramic receptacle 61, as shown in Fig. 7. The metal lid 64 is made of the above-mentioned metal and is a disk (Fig. 8) or a rectangular sheet. In an embodiment of the present invention, the above-mentioned laser welding is carried out in an inert atmosphere so as to form a weld metal 67 joining the metal lid 64 and the metal frame 63. Thus, the pin grid array package can be hermetically sealed.

It will be obvious that the present invention is not restricted to the above-mentioned embodiments and that many variations are possible for those skilled in the art without departing from the scope of this invention.

CLAIMS.

1. A hermetically sealed package for a semiconductor device comprising: a semiconductor chip; a receptacle having a cavity for accommodating the semiconductor chip; a metal lid covering the cavity; a metal frame which is fixed on said receptacle and has a through-opening for accepting said metal lid; and a plurality of leads electrically connected to the semiconductor chip; the inside surface of said metal frame facing the outisde surface of the metal lid, and said metal frame and said metal lid being joined with a weld metal at said surfaces by laser welding.

2. A package according to claim 1 wherein the thermal expansion coefficient of said metal frame and said metal lid is equal or similar to that of said receptacle.

3. A package according to claim 1 or 2, wherein said metal frame and said metal lid comprise iron-nickel-cobalt alloy or iron nickel alloy.

4. A package according to claim 1, 2 or 3, wherein said metal frame has said through-opening comprising a first opening portion and a second opening portion being smaller than the first opening portion, said metal lid being set inside the first opening portion and covering the second opening portion.

5. A package according to any preceding claim, wherein outer lead portions of said leads project from the surface of said receptacle in which said cavity is formed.

6. A package according to any preceding claim, wherein said metal frame has an L-shape cross-section.

7. A package according to claim 1, 2, 3 or 5, wherein said metal frame has a rectangular cross-section.

8. A package according to any preceding claim, wherein said receptacle comprises ceramic.

9. A method of packaging a semiconductor chip in a hermetically sealed package, comprising the steps of:

providing a receptacle having a cavity for accommodating the semiconductor chip;

fixing a metal frame, which has a through-opening for accepting a metal lid, on said receptacle;

attaching the semiconductor chip in the cavity of said receptacle;

interconnecting pads of the semiconductor chip and inner leads of said receptacle;

setting said metal lid inside the through-opening, the outside surface of the metal lid facing the inside surface of said metal frame; and

laser welding said metal lid and said metal frame to join said outside surface and said inside surface.

10. A method according to claim 9, wherein, in said fixing step, leads are simultaneously fixed on the side surfaces of said ceramic receptacle.

11. A method according to claim 9 or 10, wherein the thermal expansion coefficient of said metal frame and said metal lid is equal or similar to that of said ceramic receptacle.

12. A method according to claim 9, 10 or 11, wherein said metal frame and said metal lid comprise iron-nickel-cobalt alloy or iron-nickel alloy.

13. A method according to any one of claims 9 to 12, wherein said metal frame has said through-opening comprising a first opening portion and a second opening portion being smaller than the first opening portion, said metal lid being set inside the first opening portion and covering the second opening portion.

14. A method according to any one of claims 9 to 13, wherein said metal frame has an L-shape cross-section.

15. A method according to claim 9, 10, 11 or 12, wherein said metal frame has a rectangular cross-section.

16. A method of packaging a semiconductor chip, comprising the steps of:

mounting the chip (50) in a recess in a housing structure (41) and making electrical connections to the said chip within the recess, and

sealing the chip within the recess by fixing a metal lid (44) to the housing structure so as to close off the mouth of the recess,

characterised in that the said housing structure includes a metal frame (43) surrounding the mouth of the recess, and the metal lid is fitted within the frame and then fixed thereto by a beam welding operation whereby the periphery of the lid is welded sealingly to an inward-facing surface of the frame.

17. A packaged semiconductor device comprising a semiconductor chip (50) mounted in a recess in a housing structure (41) and connected with electrical leads of the device, the recess being sealed off by means of a metal lid (44),

characterised in that the housing structure includes a metal frame (43) surrounding the mouth of the recess, and the metal lid is fixed within the frame by a weld (45) which seals the periphery of the lid to an inward-facing surface of the frame.

Fig. 1

Fig. 2

Fig. 3

Fig. 4

Fig. 5

Fig. 6

## Fig. 7

## Fig. 8